# EUROPEAN PATENT SPECIFICATION

(11) **EP 1 553 131 B1**
(45) Date of publication and mention of the grant of the patent: **07.11.2007**
(21) Application number: 05250045.1
(22) Date of filing: 07.01.2005
(51) Int. Cl.: C08K 3/08, C08K 3/22, C08L 65/00, C08L 67/03

(54) **Compositions with polymers for advanced materials**
Polymer- Zusamensetzungen für verbesserte Materialien
Compositions de polymères pour des matériaux perfectionnés

(30) Priority: 09.01.2004 US 754348
(43) Date of publication of application: 13.07.2005
(73) Proprietor: E.I. DU PONT DE NEMOURS AND COMPANY, Wilmington, DE 19898 (US)
(72) Inventor: Summers, John D., Chapel Hill North Carolina 27514 (US); Dueber, Thomas E., Wilmington Delaware 19801 (US); Chen, Cheng-Chung, Raleigh North Carolina 27615 (US); Fang, Xin, Newark Delaware 19711 (US); Felten, John J., Chapel Hill North Carolina 27516 (US)
(74) Representative: Towler, Philip Dean

(56) References cited:
- EP-A- 0 523 392
- EP-A- 0 559 146
- EP-A- 0 931 816
- EP-A- 1 331 245
- WO-A-93/06171
- WO-A-93/23448
- WO-A-20/04041972
- WO-A-20/04081079
- US-A- 5 359 001
- US-A- 5 399 289

## Description

### FIELD OF THE INVENTION

This invention relates to compositions, and the use of such compositions for making advanced materials. In particular, the compositions are used to make electronic device structures and in other electronic applications.

### BACKGROUND OF THE INVENTION

Electronic circuits require a number of electronic components such as resistors, capacitors, inductors, electrical conductors, thermal conductors, adhesives and encapsulants. These components can be made of ceramic or polymeric materials by using screen or stencil printing techniques to process so-called polymer thick film pastes, or by spin coating or casting of suitable compositions. Ceramic pastes are typically printed on ceramic substrates and subsequently fired at temperatures as high as 900°C or above in a furnace to generate ceramic elements. The binder for the ceramic pastes is glass, which encapsulates the functional fillers used in the composition. Polymer-based materials are generally printed on organic substrates comprised of either thermoplastic or thermosetting polymeric materials. These polymer-based boards generally require processing temperatures below 200°C to 300°C to preserve thermooxidative and dimensional stability. The binders for polymeric electronic components are generally thermosetting epoxy and phenolic polymers.

A recent trend is for passive electronic components (passives) to be embedded or integrated into the printed circuit board, typically in FR4 board. Embedded passives have the potential to reduce circuit size and cost, reduce layer counts, improve high frequency performance, improve reliability by eliminating solder joints, and increase the functionality of small electronic devices. However, embedded passives must meet high performance standards and must be manufactured in high yield, as there are limited options to rework multilayer circuit boards that may have one or more faulty embedded passive components. Consequently, a move from surface mounted passives, particularly resistors, capacitors and inductors, to embedded passives remains a major technical and economic hurdle.

Polymer thick film (PTF) resistor compositions are screenable liquids or pastes, which are used to form resistive elements in electronic applications. A PTF resistor composition includes a binder system, a conductive material (usually in fine powder form), and a suitable organic solvent. Currently, the majority of commercially available PTF resistor pastes are in the form of thermosetting or thermoplastic resin pastes with carbon or graphite powders as conductive phase. The carbon-containing PTF resistor paste can be applied on a suitable substrate using screen printing, stencil printing or other techniques. Following the drying process, the printed pastes are cured at relatively low temperatures. The cured polymer binder shrinks and compresses the conductive particles together resulting in electrical conduction between particles. The resistance of the system depends on the resistance of the materials incorporated into the polymer binder, as well as their particle sizes and load.

The resistance of PTF resistors is very much dependent on the distances between conducting particles. As a result, PTF resistors require stability to high temperatures and high moisture environments with no appreciable change in resistance. The stability of PTF resistors can be measured by several known test measurements including environments of 85°C and 85% relative humidity accelerated aging, thermal cycling performance and resistance to solder exposure. High performance PTF resistors will exhibit little if any substantial change in resistance following these tests.

PTF materials may also encounter multiple exposures to solder with wave and reflow solder operations. These thermal excursions are also a source of instability for traditional PTF resistors, particularly when printed directly on copper.

U.S. Patent No. 5,980,785 to Xi, et al. describes PTF resistor compositions containing a high melting metal, a low melting metal, a polymeric binder system, and a solvent. The preferred polymer binding system is an epoxy-based system. As stated, the thermal coefficient of resistance (TCR) is dependent on heat expansion of the binder, and low TCR is necessary for most applications.

WO 04/081079 discloses a curable dielectric polynorbornene composition and circuitboards made therefrom.

WO 04/041972 discloses a gas layer formation material comprising polynorbornene derivatives. The gas layer formed are used in microchips and microchip modules.

EP 1331 245 discloses a melt-moldable thermoplastic resin composition and a molded article and optical film both comprising the same.

EP 0931 816 discloses a resin composition comprising a thermoplastic norbornene polymer and a thermosetting resin.

US 5,399,289 discloses a composition for scavenging oxygen comprising an ethylenically unsaturated hydrocarbon polymer and a transition metal catalyst.

WO 93/23448 discloses thermostat polymer compositions comprising norbornene derivatives.

US 5,359,001 discloses polymer blends comprising a block copolymer with monomeric units derived from norbornene.

EP 0 559 146 discloses polymer compositions comprising a thermoplastic norbornene polymer. The compositions are used in medical implements.

WO 93/06171 discloses polymer blends comprising a metathesis ring opening polymerised unsatured polymer of norbornene dicarboximide monomer units.

EP 0 523 392 discloses the use of chlorinated polymers to increase the heat deflection temperature and glass transition temperature of dicyclopentadiene polymers.

Many current resistor compositions exhibit poor adhesion to copper and therefore require pre-treatment of the copper conductor traces prior to screen printing of the resistor paste. An expensive silver immersion process is presently used to passivate the copper surface, thus avoiding issues of copper surface oxidation. This added process step is both time consuming and costly. As a result, there remains a need to develop resistor compositions that do not require initial passivation of the copper surface.

As such, an object of the present invention is to provide resistor composition(s) that do not require initial passivation of the copper surface, adhere to the copper surface, and still provide stability in testing environments of 85°C and 85% relative humidity accelerated aging, for thermal cycling performance and resistance to solder exposure. Still a further object of the present invention is to provide a conductive phase designed to have a low temperature coefficient of resistance.

### SUMMARY OF THE INVENTION

The invention is directed to compositions comprising: a polymer with a glass transition temperature greater than 250°C and a water absorption of 2% or less determined by ASTM D-570; one or more metals or metal compounds; a metal adhesion promoter selected from the group consisting of a phenoxy resin, polyhydroxyphenyl ether and 2-mercaptobenzimidazole; and an organic solvent, wherein the polymer is a polynorbornene comprising molecular units of formula I 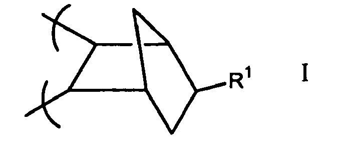 wherein R¹ is selected from hydrogen and (C₁-C₁₀) alkyl. The polymer can optionally include sites that can crosslink with one or more crosslinking agents.

The invention is also directed to a composition comprising a polymer with a glass transition temperature greater than 250°Cand a water absorption of 2% or less determined by ASTM D-570, a metal adhesive promoter selected from the group consisting of a phenoxy resin, polyhydroxyphenyl ether and 2-mercaptobenzimidazole; and an organic solvent, wherein the polymer is a polynorbornene comprising molecular units of formula I 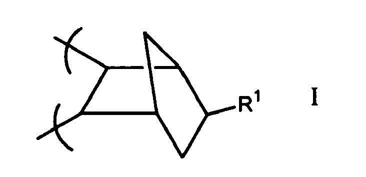 wherein R¹ is selected from hydrogen and (C₁-C₁₀) alkyl. Many of the compositions will have a cure temperature of less than 180°C.

The invention is also directed to a method of making an electronic component comprising: combining a polymer with a glass transition temperature greater than 250°C and a water absorption of less than 2% determined by ASTM D-570, one or metals or metal compounds, a metal adhesion promoter selected from the group consisting of a phenoxy resin, polyhydroxy phenyl ether and 2-mercaptobenzimidazole, and an organic solvent to provide a PTF resistor composition wherein the polymer is a polynorbornene comprising molecular units of formula I 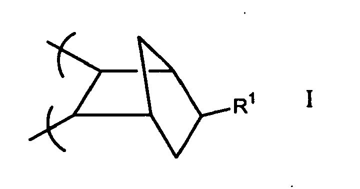 wherein R¹ is selected from hydrogen and (C₁-C₁₀) alkyl; applying the PTF resistor composition to a substrate; and curing the applied PTF resistor composition.

The inventive compositions containing the polymers can be used to produce electronic components such as resistors, discrete or planar capacitors, inductors, and electrical and thermal conductors. The compositions can also be used in a number of electronic applications such as an encapsulant, a conductive adhesive, and as an integrated circuit packaging material.

### DETAILED DESCRIPTION OF THE INVENTION

The invention is directed to a composition comprising a polymer with a glass transition temperature greater than 250°C, a water absorption of 2% or less, preferably a thermal expansion between about 20 and 65 ppm/°C; one or more metals or metal compounds; a metal adhesion promoter; and an organic solvent. The amount of water absorption is determined by ASTM D-570, which is a method known to those skilled in the art. The term "glass transition temperature" is well understood by those of ordinary skill in the art of polymer chemistry, and is determined by well-known procedures.

Applicants have also observed that polymers with a glass transition temperature greater than 290°C, preferably greater than 310°C, tend to provide cured compositions, i.e., materials, with preferred characteristics.

Applicants have also observed that polymers used in the compositions with a water absorption of 1.5% or less, preferably 1 % or less, tend to provide cured materials with preferred characteristics.

In some applications the use of a crosslinkable polymer in a composition of the invention can provide important performance advantages over the corresponding non-crosslinkable polymers. The ability of the polymer to crosslink with crosslinking agents during a thermal cure can provide electronic coatings with enhanced thermal and humidity resistance. The resulting crosslinked polymer can stabilize the binder matrix, raise the Tg, increase chemical resistance, or increase thermal stability of the cured coating compositions. Also, compared to polymers that contain no crosslinking functionality, slightly lower Tg, or slightly higher moisture absorption can be tolerated.

An exemplary list of thermal crosslinkers that can be used with the crosslinkable polymers includes a hydroxyl-capping agent such as blocked isocyanate agent and polyhydroxystyrene, novolac resins, bis-phenols, diamines and cresol formaldehyde resins. Preferred crosslinking agents are selected from the group consisting of bisphenol epoxy resin, an epoxidized copolymer of phenol and aromatic hydrocarbon, a polymer of epichlorohydrin and phenol formaldehyde, and 1,1,1-tris(p-hydroxyphenyl)ethane triglycidyl ether.

Preferably, the polynorbornene (PNB) polymer used in the compositions will have a water absorption of 1 % or less.

In another embodiment, the compositions will include PNB polymer with a glass transition temperature greater than 290°C, and a water absorption of 1 % or less.

The composition of the invention includes a PNB polymer with no crosslinkable sites as depicted by molecular units of formula I 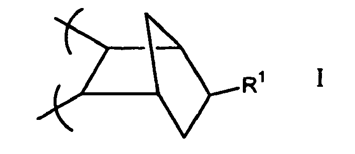 wherein R¹ is independently selected from hydrogen and a (C₁-C₁₀) alkyl. The term "alkyl" includes those alkyl groups with one to ten carbons of either a straight, branched or cyclic configuration. An exemplary list of alkyl groups includes methyl, ethyl, propyl, isopropyl and butyl.

The composition of the invention can also include a PNB polymer with crosslinkable sites as depicted by molecular units of formula II 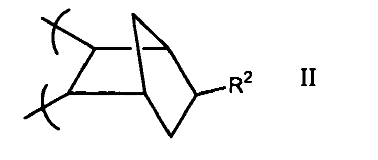 wherein R² is a pendant group capable of participating in a cross-linking or network-forming reaction. Examples include epoxides, alcohols, silyl ethers, carboxylic acids, esters such as tert-butyl ester, and anhydrides. The molar ratio of molecular units of formula II to molecular units of formula I in the PNB polymer is greater than 0 to about 0.4, or preferably greater than 0 to about 0.2. The crosslinkable epoxy group in the PNB polymer provides a site at which the polymer can crosslink with one or more crosslinking agents in the compositions of the invention as the compositions are cured. Only a small amount of crosslinkable sites on the PNB polymer is needed to provide an improvement in the cured material. For example, the compositions can include PNB polymers with a mole ratio as defined above that is greater than 0 to about 0.1.

Applicants have also observed that the use of a crosslinkable PNB polymer in a composition can provide important performance advantages over the corresponding non-crosslinkable PNB polymers. The ability of the PNB polymer to crosslink with crosslinking agents during a thermal cure can provide electronic coatings with enhanced thermal and humidity resistance. The resulting crosslinked polymer can stabilize the binder matrix, raise the Tg, increase chemical resistance, or increase thermal stability of the cured coating compositions.

The compositions include an organic solvent. The organic solvent along with the polymer serves to disperse the finely divided solids of the composition. Thus, the organic solvent should be one in which the solids are dispersible with an adequate degree of stability. Also, the solvents should have a sufficiently high boiling point to provide good screening application properties to the dispersion.

Applicants determined that certain organic solvents are particularly suited for the compositions of the invention. Such solvents include those selected from the group consisting of ether alcohols, cyclic alcohols, ether acetates, ethers, acetates, cyclic lactones, and aromatic esters. The choice of solvent will depend in part on the polymer used in the composition. Typically, if the polymer in the composition is primarily PNB then Dowanol® PPH is a preferred solvent, whereas if the polymer in the composition is primarily PA then methyl benzoate is a preferred solvent. Of course, any mixtures of the solvents can also be used in the compositions of the invention.

Most thick film compositions are applied to a substrate by screen printing, stencil printing, dispensing, doctor blading into photoimaged or otherwise preformed patterns, or other techniques known to those skilled in the art. These compositions can also be formed by any of the other techniques used in the composites industry including pressing, lamination, extrusion, molding, and the like. However, most thick film compositions are applied to a substrate by means of screen printing. Therefore, they must have appropriate viscosity so that they can be passed through the screen readily. In addition, they should be thixotropic in order that they set up rapidly after being screened, thereby giving good resolution. Although the rheological properties are of importance, the organic solvent should also provide appropriate wettability of the solids and the substrate, good drying rate, and dried film strength sufficient to withstand rough handling.

Curing of the paste or liquid composition is accomplished by any number of standard curing methods including convection heating, forced air convection heating, vapor phase condensation heating, conduction heating, infrared heating, induction heating, or other techniques known to those skilled in the art.

One advantage that the polymers provide to the compositions of the invention is a relatively low cure temperature. Many of the compositions can be cured with a temperature of less than 180°C over a reasonable time period.

It is to be understood, that the 180°C temperature is not a maximum temperature that can be reached in a curing profile. For example, the compositions can also be cured using a peak temperature up to about 270°C with a short infrared cure. The term "short infrared cure" is defined as providing a curing profile with a high temperature spike over a five minute to thirty minute period. The temperature spike is from about 40°C to about 120°C greater than the average temperature used in the cure profile.

The different coating compositions for electronic coating applications require different functional fillers that allow the required electrical, thermal or insulator property to be obtained. Functional fillers for resistors and conductors include, but are not limited to, one or more metals or metal compounds, e.g., ruthenium oxides and the other resistor materials described in U.S. Patent No. 4,814,107.

The term "metal compound" is defined as a mixture of two or more metals, or a mixture of one or more metals with an element of Groups IIIA, IVA, VA, VIA or VIIA. In particular, metal compounds including metal oxides, metal carbides, metal nitrides, and metal borides can be used in the compositions of the invention.

Functional fillers for capacitors include, but are not limited to, barium titanate, lead magnesium niobate, and titanium oxide. Functional fillers for encapsulants include, but are not limited to, fumed silica, alumina, and titanium dioxide. Encapsulant compositions can be unfilled, with only the organic binder system used, which has the advantage of providing transparent coatings for better inspection of the encapsulated component. Functional fillers for thermally conductive coatings include, but are not limited to barium nitride, graphite, beryllium oxide, silver, copper, and diamond.

PTF materials have received wide acceptance in commercial products, notably for flexible membrane switches, touch keyboards, automotive parts and telecommunications. These compositions contain resistive filler material dispersed within a polymeric binder. The compositions can be processed at relatively low temperatures, namely the temperatures required to remove the solvents in the composition and cure the polymer binder system. The actual resistivity/conductivity required for the resulting resistors will vary depending on the electronic application.

The resistive elements are usually prepared by printing the PTF composition, or ink, onto a sheet in a pattern. It is important to have uniform resistance across the sheet, i.e., the resistance of elements on one side of the sheet should be the same as that of elements on the opposite side. Variability in the resistance can significantly reduce the yield.

In addition, the resistive element should be both compositionally and functionally stable. Obviously, one of the most important properties for a resistor is the stability of the resistor over time and under certain environmental stresses. The degree to which the resistance of the PTF resistor changes over time or over the lifetime of the electronic device can be critical to performance. Also, because PTF resistors are subject to lamination of inner layers in a printed circuit board, and to multiple solder exposures, thermal stability is needed. Although some change in resistance can be tolerated, generally the resistance changes need to be less than 5%.

Resistance can change because of a change in the spacing or change in volume of functional fillers, i.e., the resistor materials, in the cured PTF resistor. To minimize the degree of volume change, the polymer should have low water absorption so the cured polymer binder does not swell if exposed to high moisture environments. Otherwise the spacing of the resistor particles will change resulting in a change in resistance.

Resistors also need to have little resistance change with temperature in the range of temperatures the electronic device is likely to be subjected to. The thermal coefficient of resistance must be low, generally less than 200 ppm/°C.

The compositions of the invention are especially suitable for providing polymer thick film (PTF) resistors. The PTF resistors made from the compositions exhibit exceptional resistor properties and are thermally stable even in relatively high moisture environments. For example, many of the PTF resistors do not exceed a change of resistance of about 10%. Most of the PTF resistors do not exceed a change of resistance of about 5%. To achieve such a small change in resistance due to heat and moisture, the polymers are characterized by a relatively high Tg and relatively low moisture absorption. Applicants determined that the most stable polymer matrix is achieved with the use of crosslinkable, high Tg polymers that also have low moisture absorption of 2% or less, preferably 1.5% or less, more preferably 1 % or less.

An additional approach found to be helpful is to treat the functional filler with a surface agent prior to combining the filler with the polyimide solution. The silane agent, γ-aminopropyltrimethoxysilane, was found to be particularly useful in the treatment of metal oxide functional fillers used in PTF resistor compositions of the invention. The silane is believed to react with the oxide surface forming a covalent bond, and the pendant amino group is believed to react with the crosslinking agent. The silane agent effectively increases the crosslinking of the polymeric binder in the cured material thus stabilizing the particle components in the PTF resistor. The result is a PTF resistor with improved performance during thermal and high humidity aging and accelerated testing. Surface treatment with a silane agent can also improve the dispersion of the functional fillers in the polyimide solution. Titanates can also be used as a surface agent to enhance the properties of a PTF resistor.

The liquid or paste compositions of the invention include one or more metal adhesion agents selected from the group consisting of a phenoxy resin, polyhydroxyphenylether and 2-mercaptobenzimidazole.

For PTF resistors the addition of phenoxy resin PKHH, a polyhydroxyphenyl ether, was unexpectedly found to improve adhesion to chemically cleaned copper. This was found to greatly improve the performance of PTF resistors to solder exposure and to accelerated thermal aging. Both thermal cycling from -25°C to 125°C, and for 85°C/85% RH thermal cycling performance was significantly improved. In fact, the combination of the PNB polymers and the phenoxy resin greatly improved the adhesion properties of the PTF resistors to such an extent that the expensive multi-step immersion silver treatment of the copper was no longer necessary. In addition, the adhesion promoter, 2-mercaptobenzimidazole (2-MB), was found to slightly improve stability of PTF resistors to solder exposure, especially at high loadings of the functional filler.

The PNB polymers can also be provided in a solution without the metals and metal compounds and used as encapsulants or in IC and wafer-level packaging as semiconductor stress buffers, interconnect dielectrics, protective overcoats (e.g. scratch protection, passivation, etch mask, etc.), bond pad redistribution, and solder bump underfills. One advantage provided by the compositions is the low curing temperature of less than 180°C or short duration at peak temperature of 270°C with short IR cure. Current packaging requires a cure temperature of about 300°C+/-25°C.

The advantages of the present invention are illustrated in the following Examples. The following discussion is directed to select embodiments of the present invention only, and nothing within this disclosure is intended to limit the overall scope of the present invention. The scope of the present invention is to be defined by the claims.

Processing and test procedures used in preparation of and testing of the compositions of the invention, and of those of the comparative examples are provided as follows.

### 3 roll milling

A three-roll mill is used for grinding pastes to fineness of grind (FOG) generally < 5µ. The gap is adjusted to 1 mil (25 µm) before beginning. Pastes are typically roll-milled for three passes at 0, 50, 100, 150, 200, 250 psi (0, 0.35, 0.69, 1.0, 1.4, 1.7 MPa) until FOG is < µ. Fineness of grind is a measurement of paste particle size. A small sample of the paste is placed at the top (25µ mark) of the grind gauge. Paste is pushed down the length of the grind gauge with a metal squeegee. FOG is reported as x/y, where x is the particle size (µm) where four or more continuous streaks begin on the grind gauge, and y is the average particle size (µm) of the paste.

### Screen printing

A 230 or 280 mesh screen and a 70 durometer squeegee are used for screen printing. Printer is set up so that snap-off distance between screen and the surface of the substrate is typically 35 mils (0.89 mm) for an 8 in x 10 in (20 cm x 25 cm) screen. The downstop (mechanical limit to squeegee travel up and down) is preset to 5mil (127 µm). Squeegee speed used is typically 1 in/second (25 mm/second), and a print-print mode (two swipes of the squeegee, one forward and one backward) is used. A minimum of 20 specimens per paste are printed. After all the substrates for a paste are printed, they are left undisturbed for a minimum of 10 minutes (so that air bubbles can dissipate), then cured 1 hr at 170°C in a forced draft oven.

### Solder float

Samples are solder floated in 60/40 tin/lead solder for 3 x 10 seconds, with a minimum of 3 minutes between solder exposures where the samples are cooled close to room temperature.

### 85°C/85% RH testing

A minimum of three specimens that have not been cover coated are placed in an 85°C/85% RH chamber and aged for 125, 250, 375 and 500hr at 85°C/85 RH. After exposure time is reached, samples are removed from the chamber, oxidation is removed from the copper leads with a wire brush and the resistance promptly determined.

### Thermal cycling

Samples of cured resistors that have not been cover coated, are subjected to thermal cycling from -25°C to + 125°C for 150 to 200 cycles with heating and cooling rates of 10°C /min with samples held at the extreme temperatures for 30 min.

### ESD

After 5 shots at 5,000 volts and 10 shots at 2,000 volts, resistance change is measured.

### TCR

TCR (thermal coefficient of resistance) is measured and reported in ppm/°C for both hot TCR (HTCR) at 125°C and cold TCR (CTCR) at -40°C.

A minimum of 3 specimens for each sample, each containing 8 resistors, is used. The automated TCR averages the results.

### Polymer film moisture absorption test

These are reported values for the polymers determined by the ASTM D570 method.

The compositions below are described in weight % for each ingredient used. The following glossary contains a list of names and abbreviations for each ingredient used:
- PNB solution: Polynorbornene Appear-3000B from Promerus at 20% solids in Dowanol® PPH
- Epoxy-PNB solution: Epoxy-containing polynorbornene from Promerus at 30% solids in beta-terpineol
- Phenoxy resin PKHH solution: Polyhydroxyphenyl ether from InChem Corp. dissolved at 23.89% solids in 70/30 Dowanol® DPM/diethylene glycol ethyl ether acetate
- AryLite™ A1000: Polyarylate with Tg 325°C and 0.3% moisture absorption from Ferrania
- Appear™-3000B: Polynorbornene with Tg 330°C and 0.03% moisture absorption from Promerus
- Ultem® 1000: Polyetherimide with Tg 215°C and 1.25% moisture absorption
- Udel®: Polysulfone with Tg 190°C and 1.3% moisture absorption
- Radel® R-5000: Polyphenylsulfone based on bisphenol A and dichlorodiphenylsulfone; polymer has Tg 220°C and 1.1 % moisture absorption
- Torlon®: Polyamideimide of trimellitic anhydride and benzidine as a 20% solution in NMP (N-methyl-2-pyrrolidone); polymer has Tg of 300°C and 2.5% moisture absorption
- Lexan®: Polycarbonate based on bisphenol A from GE
- Celazole® PBI: Polybenzimidazole with Tg 399°C and 1.06% moisture absorption
- PHS: Polyhydroxystyrene from DuPont Electronic Polymers
- 2-ethyl-4-methylimidazole: Catalyst for epoxy reaction from Aldrich
- 2-mercaptobenzimidazole (2-MB): Adhesion promoter from Aldrich
- Ruthenium dioxide (P2456): Resistor material made in DuPont Microcircuit Materials; surface area 12 m²/g
- Bismuth ruthenate (P2280): Resistor material made in DuPont Microcircuit Materials; surface area 9-10 m²/g
- Silver (P3023): Resistor material made in DuPont Microcircuit Materials; surface area 2.2-2.8 m²/g
- Alumina (R0127): Non-electrically conductive filler; surface area 7.4 to 10.5 m²/g
- Barium titanate (Z9500): Capacitor material from Ferro; surface area 3.6 m²/g, average particle size 1.2 microns
- Aluminum nitride: Thermally conductive material from Alfa Aesar; < 4 microns average particle size
- Fumed silica (R972): Viscosity modifier from Degussa; surface area 90-130 m²/g
- Graphite (HPN-10): Natural graphite from Dixon Ticonderoga Co.; surface area 0.5 m²/g

### EXAMPLES

### Examples 1 and 2

PTF resistors were prepared by using the compositions of Example 1 with a PNB polymer. The PNB polymer has a low moisture absorption and high Tg. The resulting PTF resistors exhibit excellent solder float at 230°C and excellent test results at 85°C/85% RH.

| Polymer | Example |
|---|---|
| | 1 |
| | |
| Appear™ 3000-B | 10 |
| | |
| Ruthenium dioxide powder | 21.6 |
| Bismuth ruthenate powder | 15.7 |
| Silver powder | 5.0 |
| Alumina | 4.5 |
| Dowanol PPH | 56 |

| Example | Tg (°C) | % H₂O Absorption | % Resistance Change | | | |
|---|---|---|---|---|---|---|
| | | | Solder Float (3 x 10 sec) | | | 85°C/85% RH |
| | | | 230°C | 260°C | 288°C | (500 hrs) |
| 1 | 330 | 0.03 | -0.9 | 28.4 | 205 | +1.8 |

### Example 3 (REFERENCE)

A PNB polymer with crosslinkable epoxy sites was used to prepare a PTF resistor composition. The composition also contains PHS to react with the epoxy sites on the polymer and an adhesion-promoting phenoxy resin. The resistor paste was directly printed on chemically cleaned copper, that is, without the silver immersion pre-treatment of the conductor. The PTF resistor composition was prepared from the following components (grams).

| Ingredient | % by weight |
|---|---|
| Ruthenium dioxide powder | 27.46 |
| Bismuth ruthenate powder | 19.89 |
| Silver powder | 6.44 |
| Alumina powder | 5.76 |
| Epoxy-PNB | 5.76 |
| Phenoxy resin PKHH | 4.75 |
| PHS | 3.28 |
| 2-ethyl-4-methylimidazole | 0.11 |
| Beta-terpineol | 26.55 |

The mixture was roll milled with a 1 mil (25 µm) gap with 3 passes each at 0, 50, 100, 200, 250 and 300 psi (0, 0.35, 0.69, 1.4, 1.7 and 2.1 MPa) to yield a fineness of grind of 5/2 µm. The paste was screen printed using a 280 mesh screen, and a 70 durometer squeegee, at 10 psi (69 kPa) squeegee pressure on FR-4 substrates without prior chemically cleaning with a 40 and 60 mil (1.0 and 1.5 mm) resistor pattern. The samples were baked in a forced draft oven at 170°C for 1 hr. The properties of the cured resistors are provided below. An improvement of solder float test results was observed.

| | |
|---|---|
| Resistance (ohm/square) | 198 |
| Thickness (µm) | 8.1 |
| HTCR (ppm/°C) | 149 |
| CTCR (ppm/°C) | 241 |
| % resistance change of 40 mil (1.0 mm) resistors after: | |
| 288°C solder with three 10 second floats | 2.4 |
| 500 hrs at 85°C/85% RH | -3.1 |
| Thermal cycling (-25°C to 125°C) | -2.2 . |
| ESD (5 pulses at 5,000 V) | -0.12 |

### Example 4

A non-crosslinkable PNB polymer was used to prepare a PTF resistor composition. Again, the resistor paste was directly printed on chemically cleaned copper without the immersion silver pre-treatment of the conductor pattern. The composition provided excellent resistor properties. The PTF resistor composition was prepared from the following components (grams).

| Ingredient | % by weight |
|---|---|
| Ruthenium dioxide powder | 38.99 |
| Bismuth ruthenate powder | 28.28 |
| Silver powder | 9.07 |
| Alumina powder | 8.08 |
| PNB solution | 11.63 |
| Phenoxy resin PKHH solution | 3.91 |
| 2-MB (10% solids in NMP) | 0.04 |

The mixture was roll milled with a 1 mil (25 µm) gap with 3 passes each at 0, 50, 100, 200, 250 and 300 psi (0, 0.35, 0.69, 1.4, 1.7 and 2.1 MPa) to yield a fineness of grind of 5/2 µm. The paste was screen printed using a 280 mesh screen, and a 70 durometer squeegee, at 10 psi (69 kPa) squeegee pressure on chemically cleaned FR-4 substrates with a 40 and 60 mil (1.0 and 1.5 mm) resistor pattern. The samples were baked in a forced draft oven at 170°C for 1 hr. The properties of the cured resistors wereas shown below. Samples for TCR measurement were first heat bumped to assure removal of any residual solvent.

| | |
|---|---|
| Resistance (ohm/square) | 90 |
| Thickness (µm) | 11.5 |
| HTCR (ppm/°C) | -156 |
| CTCR (ppm/°C) | 172 |
| % resistance change of 40 mil (1.0 mm) resistors after: | |
| 288°C solder with three 10 second floats | 10.1 |
| 500 hrs at 85°C/85% RH | 2.1 |
| Thermal cycling (-25°C to 125°C) | 2.1 |
| ESD (5 pulses at 5,000 V) | -0.02 |

### Example 5

A PNB polymer was used to prepare a graphite-containing PTF resistor composition. The resistor paste was directly printed on chemically cleaned copper without the immersion silver pre-treatment of the conductor pattern. The PTF resistor composition was prepared from the following components (grams).

| Ingredient | % by weight |
|---|---|
| Ruthenium dioxide powder | 14.83 |
| Bismuth ruthenate powder | 2.26 |
| Silver powder | 15.48 |
| Graphite powder | 16.13 |
| PNB solution | 27.97 |
| Phenoxy resin PKHH solution | 14.03 |
| Dowanol® PPH | 9.30 |

The mixture was roll milled with a 1 mil (25 µm) gap with 3 passes each at 0, 50, 100, 200, 250 and 300 psi (0, 0.35, 0.69, 1.4, 1.7 and 2.1 MPa) to yield a fineness of grind of 5/2 µm. The paste was screen printed using a 280 mesh screen, and a 70 durometer squeegee, at 10 psi (69 kPa) squeegee pressure on chemically cleaned FR-4 substrates with a 40 and 60 mil (1.0 and 1.5 mm) resistor pattern. The samples were baked in a forced draft oven at 170°C for 1 hr. The properties of the cured resistors were:

| | |
|---|---|
| Resistance (ohm/square) | 25.4 |
| Thickness (µm) | 15.3 |

### Comparative Examples 1 to 4

Several commercial thermoplastic polymers systems were evaluated to assess performance in resistor PTF compositions. These compositions did not contain thermal crosslinkers or adhesion promoting resin. The comparative PTF compositions were prepared from the following components (grams).

| Ingredient | Comparative Example | | | |
|---|---|---|---|---|
| | 1 | 2 | 3 | 4 |
| Ultem® 1000 | 10 | | | |
| Radel® R-5000 | | 10 | | |
| Udel® | | | 10 | |
| Lexan® | | | | 10 |
| Ruthenium dioxide powder | 21.6 | 21.6 | 21.6 | 21.6 |
| Bismuth ruthenate powder | 15.7 | 15.7 | 15.7 | 15.7 |
| Silver powder | 5.0 | 5.0 | 5.0 | 5.0 |
| Alumina powder | 4.5 | 4.5 | 4.5 | 4.5 |
| NMP | 40 | 40 | 40 | 40 |

The compositions were then screen printed according to the procedure provided in Example 1 on chemically cleaned copper, cured at 170°C for 1 hr and tested as in Example 1. The compositions were evaluated as PTF resistor compositions for solder float and 85°C/85% RH accelerated age performance. Equilibrium water uptake numbers from the ASTM D-570 method were used. The test results are provided below indicating a large % resistance change.

| Comparative Example RH | Tg (°C) | % H₂O Absorption | % Resistance Change | |
|---|---|---|---|---|
| | | | Solder Float (3 x 10 sec) | 85°C/85% |
| | | | | |
| | | | 230°C | (500 hrs) |
| 1 | 220 | 0.8 | +30 | -5.5 |
| 2 | 220 | 1.1 | +36 | -15 |
| 3 | 190 | 1.3 | +42 | -12 |
| 4 | 145 | 0.4 | +47 | +3.1 |

As the data indicate, the comparative resistor compositions prepared with polymers having a relatively low Tg result in poor resistance stability with solder exposure.

### Comparative Examples 5 and 6

Several commercial thermoplastic polymers systems were evaluated to assess performance in resistor PTF compositions. These compositions did not contain thermal crosslinkers or adhesion promoting resin. The comparative PTF compositions were prepared according to the procedure in Comparative Examples 1 to 4 from the following components (grams).

| Ingredient | Comparative Example | |
|---|---|---|
| | 5 | 6 |
| Celazole® PBI (CM) | 10 | |
| Torlon® | | 10 |
| Ruthenium dioxide powder | 21.6 | 21.6 |
| Bismuth ruthenate powder | 15.7 | 15.7 |
| Silver powder | 5.0 | 5.0 |
| Alumina | 4.5 | 4.5 |
| NMP | 40 | 40 |

| Comparative Example | Tg (°C) | % H₂O Absorption | % Resistance Change | |
|---|---|---|---|---|
| | | | Solder Float (3 × 10 sec) | 85°C/85% RH |
| | | | 230°C | (500 hrs) |
| 5 | 400 | 5.0 | -0.6 | -28.0 |
| 6 | 300 | 2.5 | -1.6 | -18 |

As the data indicate, the comparative resistor compositions prepared with polymers having >1% water absorption have poor resistance stability with 85°C/85% RH testing.

### Comparative Example 7

Commercially available Asahi paste TU-100-8 was screen printed as in Example 2 on chemically cleaned copper, and cured at 170°C for 1 hr. The properties of the resulting cured resistor were:

| | |
|---|---|
| Resistance (ohm/square) | 50 |
| Thickness (µm) | 30 |
| HTCR (ppm/°C) | -359 |
| CTCR (ppm/°C) | -172 |
| % resistance change of 40 mil (1.0 mm) resistors after: | |
| 288°C solder with three 10 second floats | -10.2 |
| 500 hrs at 85°C/85% RH | 62 |
| Thermal cycling (-25°C to 125°C) | 4.0 |
| ESD (5 pulses at 5,000 V) | -2.6 |

### Example 6

This example illustrates the utility of the use of a non-crosslinkable PNB polymer with high Tg and low water absorption to prepare a PTF capacitor composition. The PTF capacitor composition was prepared from the following components (grams).

| Ingredient | % by weight |
|---|---|
| Barium titanate powder | 58.02 |
| PNB solution | 23.07 |
| Phenoxy resin PKHH solution | 7.54 |
| Dowanol® PPH | 11.37 |

The mixture was roll milled using a 1.0 mil (25 µm) gap with at least 1 pass each at 0, 50, 100, 200, 250 psi (0, 0.35, 0.69, 1.4, 1.7 MPa) to yield a fineness of grind of 5/2. The dielectric was then printed using an AMI polymer thick film screen printer in print-print mode with a 70 durometer squeegee. A 280 mesh screen with a 0.4 mil (25 µm) emulsion thickness was imaged to print sixteen discrete capacitors on the treated side of a copper foil. The print was then cured at 80°C for 5 minutes. A second print was prepared using the same process. The capacitors on the copper foil were then cured at 170°C for 1 hr. A copper-based conductor paste was printed on the cured dielectric and cured at 150°C for 30 min to form the top electrode and yield capacitors with the following properties: The results based on averages of measurements of 16 individual capacitors:

| | |
|---|---|
| Ave capacitance | 9.8 nF/in² (1.5 nF/cm²) |
| Ave loss | 1.2% |
| Average thickness: | 1.1 mil (28 µm) |
| Apparent K | 48 |

### Example 7

This example illustrates the utility of the use of a non-crosslinkable PNB polymer with a high Tg and low water absorption to prepare a PTF cast on copper capacitor composition. The PTF capacitor composition was prepared from the following components (grams).

| Ingredient | % by weight |
|---|---|
| Barium titanate powder | 23.10 |
| PNB solution | 40.72 |
| Phenoxy resin PKHH solution | 20.30 |
| Ethyl acetate | 15.88 |

For the cost on copper (COC) sample preparation, the dispersion was solution cast with a 1 mil (25 µm) doctor knife of 1 mil (25 µm) double treated copper. The coating was dried 10 minutes at 100°C, and 1 hour at 170°C. For the determination of capacitance density (C/A), a 1 inch x 1 inch (25 mm x 25 mm) coating of DuPont CB 200 copper conductive paste was applied on the COC sample, followed by curing at 170°C for 15 minutes. Capacitance (top probe on copper pad, bottom probe on base film copper margin) was determined as 3.0 nF/in² (0.46 nF/cm²) with 2% average loss. Thickness was found to be 0.95 mil (24 µm). The dielectric constant was determined to be 12.5 at 1 Hz.

For the adhesion test for the COC coating, a sheet of 3M's pressure sensitive adhesive, Product #8141, was laminated on a 3 inch x 5 inch (76 mm x 127 mm) glass plate. Several 1 inch wide strips of COC coating that were dried 10 min at 100°C were hand-roll-laminated with the coating side against the pressure sensitive adhesive. The COC coating was peeled back from the copper sufficiently to allow peel testing with an IMAS SP-2000 peel tester, using a 2 Kg cell capacity, 2 second delay time, 20 sec averaging time, 12"/minute (30 cm/minute) speed, and a 180° angle. Peel strength was determined as 3.3 pli.

### Example 8

This example illustrates the use of a non-crosslinkable PNB polymer with a high Tg and low water absorption with a Phenoxy resin to obtain a PTF conductor composition. The PTF conductor composition was prepared from the following components (grams).

| Ingredient | % by weight |
|---|---|
| Silver powder | 57.22 |
| PNB solution | 23.32 |
| Phenoxy resin PKHH solution | 11.70 |
| Dowanol® PPH | 7.76 |

The mixture was roll milled with a 1.5 mil (38 µm) gap to yield a fineness of grind of 8/5. The pressure was set not to exceed 200 psi (1.4 MPa). A 1000 square serpentine pattern was imaged in a 230 mesh screen with a 0.5 mil (13 µm) emulsion. The conductor was then printed using an AMI polymer thick film screen printer in print-print mode with a 70 durometer squeegee. The conductor paste was printed on blank ceramic coupons and cured at 170°C for 1 hr then 200°C for two minutes. The resistance of the conductor trace was measured to be 38 milliohms/square.

### Example 9

This example illustrates the use of a non-crosslinkable PNB polymer with a high Tg and low water absorption with a Phenoxy resin to obtain an encapsulant composition. The encapsulants composition was prepared from the following components (grams).

| Ingredient | % by weight |
|---|---|
| Fumed silica | 3.20 |
| PNB solution | 48.78 |
| Phenoxy resin PKHH solution | 31.77 |
| Dowanol® PPH | 16.25 |

The mixture was roll milled using a 1.0 mil (25 µm) gap with at least 1 pass each at 0, 50, 100, 200, 250 psi (0, 0.35, 0.69, 1.4, 1.7 MPa) to yield a homogeneous paste with a fineness of grind of less than 5 microns. The encapsulant was then printed using an AMI polymer thick film screen printer in print-print mode with a 70 durometer squeegee. A 120 mesh screen with a 1 mil (25 µm) emulsion thickness was imaged to print a continuous coating over discrete 40 and 60 mil (1.0 and 1.5 mm) resistors that had been printed and cured at 170°C for 1 hour to remove printing solvents and to form a continuous consolidated polymeric coating covering the resistors. The coating was hazy in appearance. The resistors exhibited an average drift of 3.7 percent after 700 hours of 85/85 testing.

### Example 10

This example illustrates the use of a same high Tg and low water absorption with a Phenoxy resin to obtain an encapsulant composition. The encapsulants composition was prepared from the following components (grams).

| Ingredient | % by weight |
|---|---|
| PNB solution | 11.57 |
| Phenoxy resin PKHH solution | 9.72 |
| Dowanol® PPH | 78.72 |

A homogeneous solution was formed with the above ingredients. Unlike example 7, the solution was not roll milled. The encapsulant was then printed using an AMI polymer thick film screen printer in print-print mode with a 70 durometer squeegee. A 120 mesh screen with a 1 mil (25 µm) emulsion thickness was imaged to print a continuous coating over discrete 40 and 60 mil (1.0 and 1.5 mm) resistors that had been printed and cured at 170°C for 1 hour to remove printing solvents. A slightly cloudy, continuous consolidated polymeric coating formed over the resistors. The resistors exhibited an average drift of 4.4 percent after 700 hours of 85/85 testing.

## Claims

1. A composition comprising:
a polymer with a glass transition temperature greater than 250°C and a water absorption of 2% or less determined by ASTM D-570;
one or more metals or metal compounds;
a metal adhesion promoter selected from the group consisting of a phenoxy resin, polyhydroxyphenyl ether and 2-mercaptobenzimidazole; and
an organic solvent,
wherein the polymer is a polynorbornene comprising molecular units of formula I 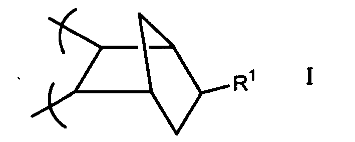 wherein R¹ is selected from hydrogen and (C₁-C₁₀) alkyl.

2. The composition of claim 1 wherein the polymer contains sites that can crosslink with one or more crosslinking agents.

3. The composition of claim 1 or claim 2 wherein the polymer is a polynorbornene that further comprises molecular units of formula II 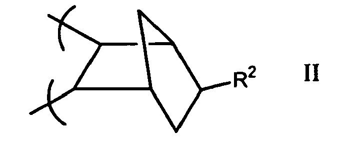 wherein R² is a pendant group capable of participating in a cross-linking or network-forming reaction selected from the group comprising: epoxides, alcohols, silyl ethers, carboxylic acids, esters, and anhydrides; and the molar ratio of molecular units of formula II to formula I is greater than 0 to about 0.4.

4. The composition of any preceding claim further comprising one or more crosslinking agents which includes polyhydroxystyrene.

5. The composition of any preceding claim further comprising a hydroxyl-capping agent.

6. The composition of claim 5 wherein the hydroxyl-capping agents is a blocked isocyanate agent.

7. The composition of any preceding claim wherein the glass transition temperature is greater than 290°C.

8. The composition of claim 7 wherein the glass transition temperature is greater than 310°C.

9. The composition of any preceding claim wherein the water absorption is 1% or less determined by ASTM 17-570.

10. The composition of any preceding claim **characterised in that** it can be cured at a temperature of less than 180°C.

11. The composition of any preceding claim **characterised in that** it can be cured at a peak temperature up to about 270°C with a short infrared cure.

12. A composition comprising a polymer with a glass transition temperature greater than 250°C and a water absorption of 2% or less determined by ASTM D-570, a metal adhesive promoter selected from the group consisting of a phenoxy resin, polyhydroxyphenyl ether and 2-mercaptobenzimidazole; and an organic solvent,
wherein the polymer is a polynorbornene comprising molecular units of formula I 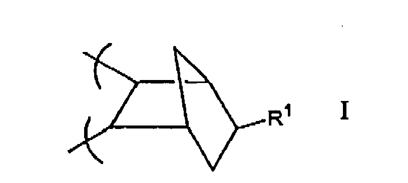 wherein R¹ is selected from hydrogen and (C₁-C₁₀) alkyl.

13. The composition of claim 12 **characterised in that** it can be cured at a temperature of less than 180°C, or at a peak temperature up to about 270°C with a short infrared cure.

14. Use of a composition of claim 12 or claim 13 as an encapsulant or an integrated circuit and wafer-level package selected from semiconductor stress buffers, interconnect dielectrics, protective overcoats bond pad redistribution, or solder bump underfills.

15. A process for making an electronic component selected from the group consisting of PTF resistors and discrete or planar capacitors, wherein the electronic component comprises a cured composition prepared by a process comprising:
providing an uncured composition of claim 1;
applying the uncured composition to a substrate; and
curing the applied composition.

16. The process of claim 15 wherein the electronic component formed is a resistor with a percent resistance change of less than ±5% with respect to the relative humidity test.

17. The process of claim 16 wherein the resistor exhibits a percent resistance change of less than ±1% with respect to an ESD test.

18. The process of claim 15 wherein the electronic component formed is a discrete or planar capacitor with a percent loss of less than 5%.

19. A method of making a PTF resistor comprising:
combining a polymer with a glass transition temperature greater than 250°C and a water absorption of less than 2%determined by ASTM D-570, one or metals or metal compounds, a metal adhesion promoter selected from the group consisting of a phenoxy resin, polyhydroxy phenyl ether and 2-mercaptobenzimidazole, and an organic solvent to provide a PTF resistor composition wherein the polymer is a polynorbornene comprising molecular units of formula I 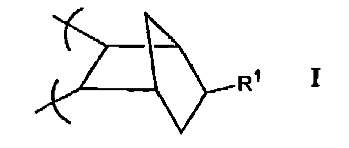
wherein R¹ is selected from hydrogen and (C₁-C₁₀) alkyl;
applying the PTF resistor composition to a substrate; and curing the applied PTF resistor composition.

20. The method of claim 19 wherein the polymer is a polynorbornene that further comprises molecular units of formula II 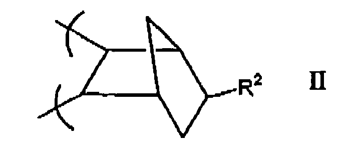 wherein R² is a crosslinkable epoxy group, and the molar ratio of molecular units of formula II to formula I is greater than 0 to about 0.4.

21. The method of any one of claim 19 or claim 20 wherein the curing of the applied PTF resistor composition is effected at a temperature of less than 180°C, or at a peak temperature up to about 270°C with a short infrared cure.

22. The method of any one of claims 19 to 21 wherein the polymer has a glass transition temperature that is greater than 290°C.

23. The method of any one of claims 19 to 22 wherein the polymer has a water absorption of 1% or less determined by ASTM D-570.

24. Use of a composition of any one of claims 1 to 11 in the preparation of a conductive adhesive.

## Patentansprüche

1. Zusammensetzung, die aufweist:
ein Polymer mit einer höheren Glasübergangstemperatur als 250°C und einer Wasseraufnahme von höchstens 2%, bestimmt nach ASTM D-570;
ein oder mehrere Metalle oder Metallverbindungen;
einen Metallhaftvermittler, der aus der Gruppe ausgewählt ist, die aus einem Phenoxyharz, Polyhydroxyphenylether und 2-Mercaptobenzimidazol besteht; und
ein organisches Lösungsmittel,
wobei das Polymer ein Polynorbornen ist, das molekulare Einheiten mit der Formel I aufweist, 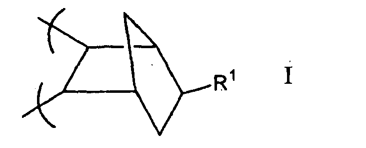 wobei R¹ unter Wasserstoff und einem (C₁-C₁₀)-Alkyl ausgewählt ist.

2. Zusammensetzung nach Anspruch 1, wobei das Polymer Stellen enthält, die sich mit einem oder mehreren Vernetzungsmitteln vernetzen können.

3. Zusammensetzung nach Anspruch 1 oder Anspruch 2, wobei das Polymer ein Polynorbornen ist, das ferner molekulare Einheiten mit der Formel II aufweist, 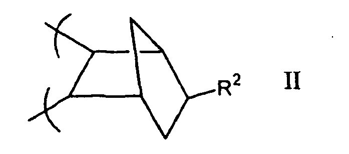 wobei R² eine an einer Vernetzungs- oder Netzwerkbildungsreaktion beteiligungsfähige Seitengruppe ist, ausgewählt aus der Gruppe, die aufweist: Epoxide, Alkohole, Silylether, Carbonsäuren, Ester und Anhydride; und wobei das Molverhältnis von molekularen Einheiten gemäß Formel II zu denen gemäß Formel I größer als 0 bis etwa 0,4 ist.

4. Zusammensetzung nach einem der vorstehenden Ansprüche, die ferner ein oder mehrere Vernetzungsmittel aufweist, zu denen Polyhydroxystyrol gehört.

5. Zusammensetzung nach einem der vorstehenden Ansprüche, die ferner ein Hydroxylblockiermittel aufweist.

6. Zusammensetzung nach Anspruch 5, wobei das Hydroxylblockiermittel ein blockiertes Isocyanat-Mittel ist.

7. Zusammensetzung nach einem der vorstehenden Ansprüche, wobei die Glasübergangstemperatur höher als 290°C ist. '

8. Zusammensetzung nach Anspruch 7, wobei die Glasübergangstemperatur höher als 310°C ist.

9. - Zusammensetzung nach einem der vorstehenden Ansprüche, wobei die Wasseraufnahme höchstens 1% beträgt, bestimmt nach ASTM D-570.

10. Zusammensetzung nach einem der vorstehenden Ansprüche, **dadurch gekennzeichnet, daß** sie bei einer Temperatur von weniger als 180°C gehärtet werden kann.

11. Zusammensetzung nach einem der vorstehenden Ansprüche, **dadurch gekennzeichnet, daß** sie bei einer Spitzentemperatur bis zu etwa 270°C mittels kurzwelliger Infrarothärtung gehärtet werden kann.

12. Zusammensetzung, die aufweist: ein Polymer mit einer höheren Glasübergangstemperatur als 250°C und einer Wasseraufnahme von höchstens 2%, bestimmt nach ASTM D-570, einen Metallhaftvermittler, der aus der Gruppe ausgewählt ist, die aus einem Phenoxyharz, Polyhydroxyphenylether und 2-Mercaptobenzimidazol besteht; und ein organisches Lösungsmittel,
wobei das Polymer ein Polynorbornen ist, das molekulare Einheiten mit der Formel I aufweist, 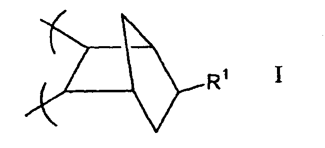 wobei R¹ unter Wasserstoff und einem (C₁-C₁₀)-Alkyl ausgewählt ist.

13. Zusammensetzung nach Anspruch 12, **dadurch gekennzeichnet, daß** sie bei einer Temperatur von weniger als 180°C oder bei einer Spitzentemperatur bis zu etwa 270°C mittels kurzwelliger Infrarothärtung gehärtet werden kann.

14. Verwendung einer Zusammensetzung nach Anspruch 12 oder Anspruch 13 als Vergußmasse oder als Verkappungsmaterial auf integrierter Schaltkreis- und Waferebene, ausgewählt unter Halbleiter-Spannungspuffern, Zwischenträger-Dielektrika, Schutzdeckschichten zur Bondinsel-Umverteilung oder Lötkontakthügel-Unterfüllungen.

15. Verfahren zur Herstellung eines elektronischen Bauelements, das aus der Gruppe ausgewählt ist, die aus Polymer-Dickschichtwiderständen (PTF-Widerständen) und Einzel- oder Planarkondensatoren besteht, wobei das elektronische Bauelement eine gehärtete Zusammensetzung aufweist, die nach einem Verfahren hergestellt wird, das aufweist:
Bereitstellen einer ungehärteten Zusammensetzung nach Anspruch 1;
Aufbringen der ungehärteten Zusammensetzung auf ein Substrat; und
Härten der aufgebrachten Zusammensetzung.

16. Verfahren nach Anspruch 15, wobei das gebildete elektronische Bauelement ein Widerstand mit einer prozentualen Widerstandsänderung von weniger als ± 5% bezüglich des Feuchtigkeitstests ist.

17. Verfahren nach Anspruch 16, wobei der Widerstand eine prozentuale Widerstandsänderung von weniger als ± 1% bezüglich des ESD-Tests (elektrostatischen Entladungstests) aufweist.

18. Verfahren nach Anspruch 15, wobei das gebildete elektronische Bauelement ein Einzel- oder Planarkondensator mit einem prozentualen Verlust von weniger als 5% ist.

19. Verfahren zur Herstellung eines PTF-Widerstands, das aufweist:
Vereinigen eines Polymers mit einer höheren Glasübergangstemperatur als 250°C und einer Wasseraufnahme von weniger als 2%, bestimmt nach ASTM D-570, eines oder mehrerer Metalle oder Metallverbindungen, eines Metallhaftvermittlers, der aus der Gruppe ausgewählt ist, die aus einem Phenoxyharz, Polyhydroxyphenylether und 2-Mercaptobenzimidazol besteht, und eines organischen Lösungsmittels zur Herstellung einer PTF-Widerstandszusammensetzung, wobei das Polymer ein Polynorbornen ist, das molekulare Einheiten mit der Formel I aufweist, 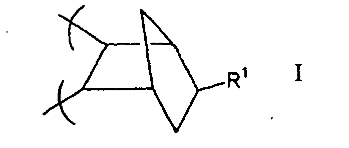
wobei R¹ unter Wasserstoff und einem (C₁-C₁₀)-Alkyl ausgewählt ist;
Aufbringen der PTF-Widerstandszusammensetzung auf ein Substrat und Härten der aufgebrachten PTF-Widerstandszusammensetzung.

20. Verfahren nach Anspruch 19, wobei das Polymer ein Polynorbornen ist, das ferner molekulare Einheiten mit der Formel II aufweist, 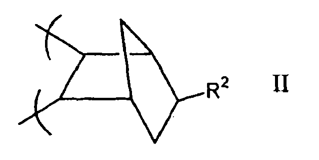 wobei R² eine vernetzbare Epoxygruppe ist und das Molverhältnis von molekularen Einheiten gemäß Formel II zu denen gemäß Formel I größer als 0 bis etwa 0,4 ist.

21. Verfahren nach einem der Ansprüche 19 oder 20, wobei die Härtung der aufgebrachten PTF-Widerstandszusammensetzung bei einer Temperatur von weniger als 180°C oder bei einer Spitzentemperatur bis zu etwa 270°C mittels kurzwelliger Infrarothärtung ausgeführt wird.

22. Verfahren nach einem der Ansprüche 19 bis 21, wobei das Polymer eine höhere Glasübergangstemperatur als 290°C aufweist.

23. Verfahren nach einem der Ansprüche 19 bis 22, wobei das Polymer eine Wasseraufnahme von höchstens 1% aufweist, bestimmt nach ASTM D-570.

24. Verwendung einer Zusammensetzung nach einem der Ansprüche 1 bis 11 bei der Herstellung eines stromleitenden Klebstoffs.

## Revendications

1. Composition comprenant :
un polymère présentant une température de transition vitreuse supérieure à 250°C et une absorption d'eau de 2 % ou moins déterminée par ASTM D-570;
un ou plusieurs métaux ou un ou plusieurs composés métalliques;
un promoteur d'adhérence métallique choisi dans le groupe qui est constitué d'une résine phénoxy, de polyhydroxyphényl éther et de 2-mercaptobenzimidazole; et
un solvant organique ;
dans laquelle le polymère est un polynorbornène comprenant des unités moléculaires de formule I 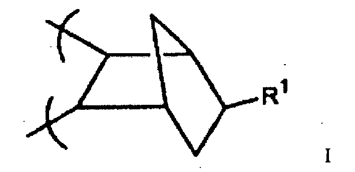 dans laquelle R¹ est choisi parmi un atome d'hydrogène et un groupe alkyle en C₁-C₁₀.

2. Composition selon la revendication 1, dans laquelle le polymère contient des sites qui peuvent réticuler avec un ou plusieurs agents de réticulation.

3. Composition selon la revendication 1 ou 2, dans laquelle le polymère est un polynorbornène qui comprend, en outre, les unités moléculaires de formule II 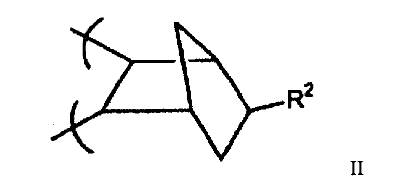 dans laquelle R² est un groupe pendant capable de participer à la réaction de réticulation ou de formation de réseau choisi dans le groupe comprenant : les époxydes, les alcools, les silyl éthers, les acides carboxyliques, les esters et les anhydrides ; et le rapport molaire des unités moléculaires de la formule II à la formule I est plus grand que 0 à environ 0,4.

4. Composition selon l'une quelconque des revendications précédentes comprenant, en outre, un ou plusieurs agents de réticulation qui incluent le polyhydroxystyrène.

5. Composition selon l'une quelconque des revendications précédentes comprenant, en outre, un agent de coiffage hydroxyle.

6. Composition selon la revendication 5, dans laquelle les agents de coiffage hydroxyle sont un agent isocyanate séquencé.

7. Composition selon l'une quelconque des revendications précédentes, dans laquelle la température de transition vitreuse est supérieure à 290°C.

8. Composition selon la revendication 7, dans laquelle la température de transition vitreuse est supérieure à 310°C.

9. Composition selon l'une quelconque des revendications précédentes, dans laquelle l'absorption d'eau est de 1% ou moins déterminée par ASTM D-570.

10. Composition selon l'une quelconque des revendications précédentes, **caractérisé en ce qu'**elle peut être durcie à une température inférieure à 180°C.

11. Composition selon l'une quelconque des revendications précédentes, **caractérisé en ce qu'**elle peut être durcie à une température pic allant jusqu'à environ 270°C avec un durcissement au rayon infrarouge court.

12. Composition comprenant un polymère ayant une température de transition vitreuse supérieure à 250°C et une absorption d'eau de 2 % ou moins déterminée par ASTM D-570, un promoteur d'adhérence métallique choisi dans le groupe constitué d'une résine phénoxy, de polyhydroxyphényl éther et de 2-mercaptobenzimidazole ; et un solvant organique,
dans laquelle le polymère est un polynorbornène comprenant les unités moléculaires de formule I 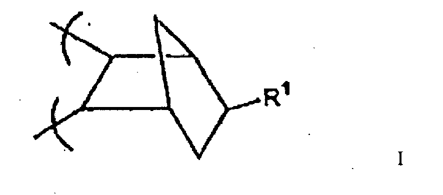 dans laquelle R¹ est choisi parmi un atome d'hydrogène et un groupe alkyle en C₁-C₁₀.

13. Composition selon la revendication 12, **caractérisé en ce que** elle peut être durcie à une température inférieure à 180°C ou à une température pic allant jusqu'à environ 270°C avec un durcissement au rayon infrarouge court.

14. Utilisation d'une composition selon la revendication 12 ou 13 comme encapsulant ou comme boîtier de circuit intégré et boîtier au niveau tranche choisi parmi les tampons de contrainte de semiconducteur, les diélectriques d'interconnexion, les revêtements de protection, le redistribution de plots de connexion ou la sous-charge de perle de soudure.

15. Procédé pour fabriquer un composant électronique choisi dans le groupe qui est constitué de résistances PTF et des condensateurs discrets ou plans, dans lequel le composant électronique comprend une composition durcie préparée par un procédé comprenant les étapes consistant à :
fournir une composition non durcie de la revendication 1 ;
appliquer la composition non durcie à un substrat ; et
durcir la composition appliquée.

16. Procédé selon la revendication 15, dans lequel le composant électronique formé est une résistance avec un changement de valeur ohmique en pour cent inférieur à ± 5 % par rapport au test d'humidité relative.

17. Procédé selon la revendication 16, dans lequel la résistance présente un changement de valeur ohmique en pour cent inférieur à ± 1 % par rapport à un test ESD.

18. Procédé selon la revendication 15, dans lequel le composant électronique formé est un condensateur discret ou plan avec une perte en pourcentage inférieure à 5 %.

19. Procédé de fabrication d'une résistance PTF comprenant les étapes consistant à:
combiner un polymère avec une température de transition vitreuse supérieure à 250°C et une absorption d'eau inférieure à 2 % déterminée par l'ASTM D-570, un ou plusieurs métaux ou un ou plusieurs composés métalliques, un promoteur d'adhérence métallique choisi dans le groupe constitué d'une résine phénoxy, de polyhydroxy phényl éther et de 2-mercaptobenzimidazole et d'un solvant organique pour fournir une composition de résistance PTF, dans laquelle le polymère est un polynorbornène comprenant des unités moléculaires de formule I 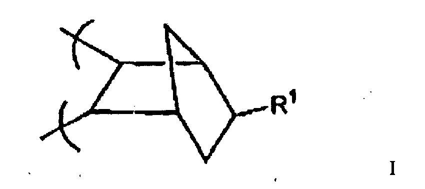
dans laquelle R¹ est choisi parmi un atome d'hydrogène et un groupe alkyle en C₁-C₁₀;
appliquer la composition de résistance PTF à un substrat ; et durcir la composition de résistance PTF appliquée.

20. Procédé selon la revendication 19, dans lequel le polymère est un polynorbornène qui comprend, en outre, les unités moléculaires de formule II 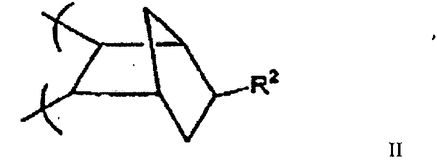 dans laquelle R² est un groupe époxy réticulable et le rapport molaire des unités moléculaires de formule II à formule 1 est supérieur à 0 à environ 0,4.

21. Procédé selon l'une quelconque des revendications 19 ou 20, dans lequel le durcissement de la composition de résistance PTF appliquée est effectué à une température inférieure à 180°C, ou à une température pic allant jusqu'à environ 270°C avec un durcissement au rayon infrarouge court.

22. Procédé selon l'une quelconque des revendications 19 à 21, dans lequel le polymère présente une température de transition vitreuse qui est supérieure à 290°C.

23. Procédé selon l'une quelconque des revendications 19 à 22, dans lequel le polymère présente une absorption d'eau de 1 % ou moins déterminée par ASTM D-570.

24. Utilisation d'une composition selon l'une quelconque des revendications 1 à 11 dans la préparation d'un adhésif conducteur.
